(19) Europäisches Patentamt
European Patent Office
Office européen des brevets

(11) Veröffentlichungsnummer : **0 134 574**
**B1**

(12) # EUROPÄISCHE PATENTSCHRIFT

(45) Veröffentlichungstag der Patentschrift : **16.06.87**

(51) Int. Cl.⁴ : **G 03 F 7/10**, G 03 F 7/26

(21) Anmeldenummer : **84110288.2**

(22) Anmeldetag : **29.08.84**

(54) **Als positiv arbeitendes Aufzeichnungsmaterial geeignetes lichtempfindliches, härtbares Gemisch.**

(30) Priorität : **02.09.83 DE 3331691**

(43) Veröffentlichungstag der Anmeldung : **20.03.85 Patentblatt 85/12**

(45) Bekanntmachung des Hinweises auf die Patenterteilung : **16.06.87 Patentblatt 87/25**

(84) Benannte Vertragsstaaten : **BE CH DE FR GB IT LI NL**

(56) Entgegenhaltungen :
**DE-A- 2 150 691**
**DE-A- 2 309 062**

(73) Patentinhaber : **BASF Aktiengesellschaft**
**Carl-Bosch-Strasse 38**
**D-6700 Ludwigshafen (DE)**

(72) Erfinder : **Schupp, Hans, Dr.**
**Gartenweg 10**
**D-6706 Wachenheim (DE)**
Erfinder : **Elzer, Albert, Dr.**
**Pappelstrasse 4**
**D-6701 Otterstadt (DE)**
Erfinder : **Jaeckel, Klaus-Peter, Dr.**
**Uhlandweg 13**
**D-7602 Oberkirch (DE)**
Erfinder : **Leyrer, Reinhold J., Dr.**
**Menzelstrasse 4**
**D-6700 Ludwigshafen (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 134 574 B1

**Beschreibung**

Die Erfindung betrifft ein als positiv arbeitendes Aufzeichnungsmaterial geeignetes, insbesondere festes, lichtempfindliches, härtbares Gemisch, welches als lichtempfindliche Komponente ein aromatische und/oder heteroaromatische o-Nitrocarbinolestergruppierungen tragendes Polymeres enthält. Die Erfindung betrifft desweiteren Aufzeichnungsmaterialien mit einer auf einem dimensionsstabilen Träger aufgebrachten lichtempfindlichen, härtbaren Schicht auf Basis dieser Gemische sowie deren Verwendung zur Herstellung von temperaturstabilen Reliefbildern, Reliefformen oder Resistmustern, insbesondere Lötstoppmasken.

In der DE-C-2 150 691 sowie der DE-A-2 922 746 werden positiv arbeitende Aufzeichnungsmaterialien für die Herstellung von Reliefbildern oder Resistmustern beschrieben, deren lichtempfindliche Schicht auf Basis von o-Nitrocarbinolestergruppierungen enthaltenden Polymeren aufgebaut ist, die nach der Belichtung mit einem alkalischen Lösungsmittel ausgewaschen werden können. Gemäß der DE-C-2 150 691 können diese o-Nitrocarbinolestergruppierungen tragenden Polymeren zusätzlich auch noch weitere funktionelle Gruppen, wie beispielsweise Nitril-, Amid-, Amino-, Hydroxy-, N-Methylol- oder Epoxi-Gruppen eingebaut enthalten. Diese bekannten Beschichtungsmaterialien, die sich für die Herstellung von Resistschichten oder Flachdruckplatten eignen, sind zwar im unbelichteten Zustand gegenüber thermischer Beanspruchung unempfindlich, so daß sie eine hohe Lagerstabilität aufweisen und eine einfache Verarbeitbarkeit, beispielsweise durch Schichtübertragung, erlauben. Die Temperaturstabilität dieser Beschichtungsmaterialien nach dem Belichten und Entwickeln ist für viele Anwendungszwecke jedoch unzureichend, da die Festigkeit der hiermit hergestellten Resistschichten oberhalb 50 °C stark abnimmt. Weiterhin besitzen die hiermit hergestellten Reliefbilder und Resistmuster nur eine begrenzte Lösungsmittel-Beständigkeit, die für viele Anwendungszwecke weiter verbesserungsbedürftig ist. Darüber hinaus ist auch die Kriechstromfestigkeit dieser Materialien noch nicht befriedigend, so daß sie sich für die Verwendung als Lötstoppmasken, beispielsweise bei der Herstellung von gedruckten Schaltungen, im allgemeinen nicht eignen.

Aus der DE-B-2 309 062 ist es ferner bekannt, aus lichtempfindlichen Schichten, die eine aromatische o-Nitrocarbinolestergruppierungen aufweisende Verbindung und zusätzlich ein Epoxiharzpräpolymeres enthalten, Reliefbilder oder Resistmuster herzustellen, indem man die lichtempfindliche Schicht bildmäßig belichtet, durch eine Wärmebehandlung in der belichteten Schicht das durch die Belichtung hervorgerufene latente Bild selektiv härtet und anschließend die unbelichteten, ungehärteten Schichtanteile mit einem Lösungsmittel entfernt. Entsprechend der Lehre der DE-B-2 309 062 kann die o-Nitrocarbinolestergruppierungen aufweisende Verbindung ein Polymeres sein und die lichtempfindliche Schicht zusätzlich Füllstoffe enthalten. Die selektive thermische Härtung der bildmäßig belichteten Schicht ist notwendig, um eine hinreichende Löslichkeitsdifferenzierung zwischen den belichteten und unbelichteten Schichtanteilen zu erreichen und so die Entwicklung der Reliefbilder oder Resistmuster zu ermöglichen. Dementsprechend ist das Verfahren gemäß der DE-B-2 309 062 negativ arbeitend und bedarf darüberhinaus organischer Lösungsmittel zur Entwicklung der belichteten und selektiv gehärteten Schicht. Die gemäß der DE-B-2 309 062 hergestellten Reliefbilder oder Resistmuster besitzen ferner nur eine geringe thermische Stabilität und für viele Anwendungszwecke nur eine unzureichende Lösungsmittel-Stabilität. Gemäß der DE-B-2 309 062 ist die Herstellung von technisch brauchbaren Lötstoppmasken nicht möglich.

Um mit den lichtempfindlichen Gemischen und Beschichtungsmaterialien wie sie in der DE-C-2 150 691 und der DE-B-2 309 062 beschrieben sind, in positiv arbeitenden Verfahren, bei gleichzeitiger Einsatzmöglichkeit von wäßrigen Entwickler-Lösungsmitteln, zu Reliefbildern oder Resistmustern mit guter, verbesserter Temperaturstabilität und hoher Beständigkeit gegenüber Chemikalien und Lösungsmitteln zu gelangen, wie sie auch als Lötstoppmasken Einsatz finden können, wird in den älteren Patentanmeldungen DE-A-3 231 144 und DE-A-3 231 147 ein Verfahren beschrieben, bei dem die nach der bildmäßigen Belichtung und Entwicklung erhaltenen Reliefbilder oder Resistmuster noch einmal vollflächig mit aktinischem Licht nachbelichtet und anschließend thermisch gehärtet werden. Zur Erzielung von temperaturbeständigen Reliefbildern oder Resistmustern bedarf es hiernach somit eines zusätzlichen Verfahrensschrittes. Auch wird nach diesem Verfahren die thermische Härtung vorzugsweise in mehreren Stufen bei steigenden Temperaturen vorgenommen, um eine Beeinträchtigung der Reliefstruktur bei hohen Härtungstemperaturen zu vermeiden.

Aufgabe der vorliegenden Erfindung war es, ein als positiv arbeitendes Aufzeichnungsmaterial geeignetes, lichtempfindliches, härtbares Gemisch aufzuzeigen, welches bei guten Belichtungseigenschaften und hohem Auflösungsvermögen in Schichten beliebiger Dicke die Herstellung von Reliefbildern, Reliefformen oder Resistmustern, insbesondere auch Lötstoppmasken, gestattet, die eine gute thermische Stabilität, hohe mechanische Festigkeit, gute Resistenz gegenüber Chemikalien und Lösungsmitteln sowie darüberhinaus gute isolatorische Eigenschaften, wie Kriechstrom- und Durchschlagsfestigkeit, besitzen. Die lichtempfindlichen, härtbaren Gemische bzw. die hieraus hergestellten Aufzeichnungsmaterialien sollen nach möglichst einfachen Verfahren verarbeitbar sein, mit wäßrigen Entwickler-Lösungsmitteln ausgewaschen werden können, sowohl vor als auch insbesondere nach der Belichtung und Entwicklung der Reliefbilder, Reliefformen oder Resistmuster eine sehr gute Haftung auf

permanenten Trägermaterialien aufweisen und zu Produkten mit exakter, vorlagengetreuer Bildwiedergabe und ausgezeichneten Reliefstrukturen verarbeitbar sein.

Es wurde nun gefunden, daß diese Aufgabe durch ein lichtempfindliches, härtbares Gemisch gelöst wird, welches neben einem Polymeren mit aromatischen und/oder heteroaromatischen o-Nitrocarbinolestergruppierungen sowie mit mindestens zwei weiteren funktionellen, reaktiven Gruppen eine vernetzend wirkende Verbindung, die unter dem Einfluß von Wärme mit den weiteren funktionellen, reaktiven Gruppen des Polymeren zu reagieren vermag, mindestens einen Füllstoff sowie gegebenenfalls weitere übliche Zusatz- und/oder Hilfsstoffe enthält.

Gegenstand der Erfindung ist demzufolge ein als positiv arbeitendes Aufzeichnungsmaterial geeignetes lichtempfindliches, härtbares Gemisch von

(a) einem Polymeren mit einem Molekulargewicht > 500, wobei das Polymere (a) ein Copolymerisat aus mit aromatischen und/oder heteroaromatischen o-Nitrocarbinolen veresterten olefinisch ungesättigten Carbonsäuren, weitere funktionelle, reaktive Gruppen enthaltenden olefinisch ungesättigten Monomeren sowie gegebenenfalls weiteren Comonomeren ist, welches mindestens 5 Gew.%, bezogen auf das Molekulargewicht des Polymeren, aromatische und/oder heteromatische o-Nitrocarbinolestergruppierungen sowie zusätzlich mindestens zwei weitere, funktionelle, der Reaktion mit einem thermischen Vernetzer zugängliche, reaktive Gruppen, ausgewählt aus Hydroxyl-, Amin-, Amid-, N-Methylolamid, Epoxid- und/oder verkappte Isocyanat-Gruppen, eingebaut enthält,
(b) einer vernetzend wirkenden Verbindung, ausgewählt aus niedermolekularen oder hochmolekularen Verbindungen mit mindestens zwei Epoxid-, verkappten Isocyanat-, Amid-, N-Methylolamid-, Hydroxyl- und/oder Amingruppen, die unter dem Einfluß von Wärme bei Temperaturen deutlich oberhalb Raumtemperatur mit den weiteren funktionellen, reaktiven Gruppen des Polymeren (a) zu reagieren vermag,
(c) einem oder mehreren Füllstoffen sowie gegebenenfalls
(d) weiteren üblichen Zusatz- und/oder Hilfsstoffen.

Gegenstand der Erfindung sind weiterhin positiv arbeitende Aufzeichnungsmaterialien mit einer auf einem dimensionsstabilen Träger aufgebrachten lichtempindlichen, härtbaren Schicht, welche dadurch gekennzeichnet sind, daß die lichtempflindliche, härtbare Schicht aus einem Gemisch der vorstehend bezeichneten Art gebildet wird. Gegenstand der Erfindung ist weiterhin die Verwendung dieser lichtempfindlichen, härtbaren Gemische bzw. Aufzeichnungsmaterialien zur Herstellung von temperaturstabilen Reliefbildern, Reliefformen oder Resistmustern, insbesondere zur Herstellung von Lötsstoppmasken.

Bei der Belichtung mit aktinischem Licht werden die o-Nitrocarbinolestergruppierungen unter Bildung von in dem Polymeren (a) gebundenen, freien Carboxylgruppen gespalten, wodurch eine deutliche Löslichkeitsdifferenzierung zwischen den belichteten und unbelichteten Bereichen erzeugt wird und die belichteten Anteile des Gemisches mit wäßrigen Entwicklerlösungsmitteln entfernt werden können. Bei Temperaturerhöhung reagieren die im Polymeren (a) enthaltenen weiteren funktionellen, reaktiven Gruppen mit den in dem Gemisch enthaltenen vernetzend wirkenden Verbindungen (b), so daß ein unlösliches, mechanisch, chemisch und thermisch widerstandsfähiges Produkt entsteht. Der in dem lichtempfindlichen, härtbaren Gemisch enthaltene Füllstoff dient u. a. der Ausbildung scharfer und exakter Bildkonturen und Reliefstrukturen mit steilen Flanken. Ein besonderer Vorteil der erfindungsgemäßen lichtempfindlichen, härtbaren Gemische besteht darin, daß hieraus hergestellte Schichten zum einen lichtempfindlich sind, auf der anderen Seite aber in einem davon unabhängigen Schritt thermisch vernetzt werden können, ohne daß das optische Auflösungsvermögen leidet und ohne daß eine Begrenzung der Lagerstabilität bei Raumtemperatur gegeben ist. Hervorzuheben sind auch die guten Haftungseigenschaften der erfindungsgemäßen Gemische bzw. der hieraus hergestellten Schichten, insbesondere im belichteten und gehärteten Zustand, auf üblichen Trägermaterialien und Substraten, insbesondere Metalloberflächen oder den Basismaterialien für gedruckte Schaltungen.

Als lichtempfindliche Verbindung ist in den erfindungsgemäßen Gemischen ein Polymer (a) mit einem mittleren Molekulargewicht (Zahlenmittel) von > 500, insbesondere im Bereich von 10 000 bis 100 000 enthalten, welches mindestens 5 Gew.%, bezogen auf das Molekulargewicht des Polymeren, an aromatischen und/oder heteroaromatischen o-Nitrocarbinolestergruppierungen im Molekül gebunden enthält. Diese o-Nitrocarbinolestergruppierungen entsprechen insbesondere der allgemeinen Formel (I)

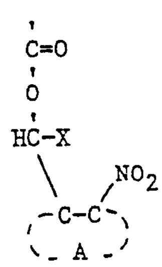

(I)

in der A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 C-Atomen oder einen gegebenenfalls substituierten Aryl- oder Aralkylrest bedeuten. Neben den o-Nitrocarbinolestergruppierungen enthält das Polymer (a) ferner noch mindestens zwei weitere, funktionelle reaktive Gruppen, die der thermischen Vernetzungsreaktion mit der vernetzend wirkenden Verbindung (b) zugänglich sind. Als Komponente (a) kommen die an sich bekannten, vorzugsweise o-Nitrocarbinolestergruppierungen der allgemeinen Formel (I) enthaltenden Polymeren in Betracht, wie sie insbesondere in der DE-C-2 150 691 beschrieben sind.

Beispiele für das aromatische oder heteroaromatische Ringsystem A in den Gruppierungen der allgemeinen Formel (I), welches ein- oder mehrkernig sein kann, sind neben Naphthalin, Anthracen, Anthrachinon oder Phenanthren insbesondere das unsubstituierte oder substituierte Benzol. Als Substituenten für das aromatische Ringsystem A kommen neben der Nitrogruppe in o-Stellung beispielsweise Alkylreste mit 1 bis 8 C-Atomen, Alkoxyreste mit 1 bis 6 C-Atomen, Halogenatome, wie Chlor oder Brom, Nitro-, Amino-, Nitril- oder Sulfo-Gruppen in Betracht. Als Beispiel für heteroaromatische Ringsysteme sei der Pyridinrest genannt. Zu den bevorzugten o-Nitrocarbinolen, die den o-Nitrocarbinolestergruppierungen der allgemeinen Formel (I) zugrunde liegen, gehören beispielsweise o-Nitrobenzylalkohol, 2-Nitro-6-chlor-benzylalkohol, 2-Nitro-4-cyanobenzylalkohol, 2-Nitro-4,5-dimethoxybenzylalkohol, α-Methyl-o-nitrobenzylalkohol, α-Phenyl-o-nitrobenzylalkohol, α-(o-Nitrophenyl)-o-nitrobenzylalkohol und 2-Nitro-3-hydroxymethylpyridin.

Bei dem den lichtempfindlichen Polymeren (a) zugrundeliegenden Basispolymeren handelt es sich zweckmäßigerweise um Copolymerisate von olefinisch ungesättigten Mono- oder Dicarbonsäuren, insbesondere um Copolymerisate von α,β-ungesättigten Mono- oder Dicarbonsäuren mit 3 bis 6 C-Atomen, wie z. B. von Acrylsäure, Methacrylsäure, Maleinsäure, Fumarsäure und/oder Crotonsäure. Für das in den erfindungsgemäßen Gemischen einzusetzende lichtempfindliche Polymer (a) sind die freien Carboxylgruppen dieser Copolymerisate von ungesättigten Carbonsäuren zumindest teilweise, vorzugsweise jedoch vollständig mit den erwähnten aromatischen und/oder heteroaromatischen o-Nitrocarbinolen verestert. Die Copolymerisate der olefinisch ungesättigten Carbonsäuren enthalten als Comonomere solche Verbindungen einpolymerisiert, die funktionelle, reaktive Gruppen enthalten, die mit der vernetzend wirkenden Verbindung (b) unter dem Einfluß von Wärme eine Reaktion eingehen können. Als funktionelle, reaktive Gruppen dieser Art sind insbesondere Hydroxyl-, Amin-, Amid-, N-Methylolamid-, Epoxid- und/oder verkappte Isocyanat-Gruppen zu nennen. Als Beispiele für entsprechende Comonomere, die solche funktionellen, reaktiven Gruppen enthalten, seien genannt : N,N-Dimethylaminoethyl-(meth)acrylat ; N-Vinylimidazol ; (Meth)acrylamid ; Monoester von Diolen mit ungesättigten Carbonsäuren, insbesondere von Acryl- oder Methacrylsäure, wie z. B. β-Hydroxyethyl-(meth)acrylat, 2-Hydroxypropyl-(meth)acrylat, 3-Hydroxypropyl-(meth)acrylat, Butandiol-mono-(meth)acrylat ; Methylolverbindungen vom Amoltyp, z. B. N-Methylolacrylamid ; Glycidylester ungesättigter Carbonsäuren, insbesondere der Acryl- oder Methacrylsäure, wie Glycidyl-(meth)-acrylat ; sowie Glycidylether ungesättigter Alkohole, wie z. B. Allylglycidylether oder 4-Vinylcyclohexendioxid.

Die Copolymerisate der olefinisch ungesättigten Carbonsäuren können darüber hinaus weitere Comonomere einpolymerisiert enthalten, wobei Ethylen, Styrol und den $C_1$-$C_8$-Alkylestern der obengenannten ethylenisch ungesättigten Carbonsäuren als zusätzlichen Comonomeren besondere Bedeutung zukommt. Geeignete Polymere (a) können beispielsweise durch Copolymerisation von aromatischen und/oder heteroaromatischen o-Nitrocarbinolestern olefinisch ungesättigter Carbonsäuren der in Rede stehenden Art, insbesondere der Acryl- und/oder Methacrylsäure, mit den funktionellen, reaktiven Gruppen enthaltenden olefinisch ungesättigten Verbindungen, insbesondere entsprechenden (Meth)acrylverbindungen, sowie gegebenenfalls weiteren Comonomeren nach an sich üblichen und bekannten Verfahren hergestellt werden.

Die Menge an aromatischen und/oder heteroaromatischen o-Nitrocarbinolestergruppierungen in dem erfindungsgemäß einzusetzenden Polymeren (a) wird im allgemeinen nicht unter 5 Gew.%, bezogen auf das Molekulargewicht des Polymeren (a), liegen und kann in Abhängigkeit insbesondere der gewünschten Eigenschaften der lichtempfindlichen Gemische in weiten Grenzen schwanken. Da bei der Belichtung mit aktinischem Licht die o-Nitrocarbinolestergruppierungen gespalten und freie Carboxylgruppen im Polymeren (a) gebildet werden, wodurch die Löslichkeit des Polymeren (a) geändert wird, sind die o-Nitrocarbinolestergruppierungen in dem Polymeren (a) maßgebend für die Löslichkeitsdifferenzierung bei der bildmäßigen Belichtung der erfindungsgemäßen lichtempfindlichen Gemische. Ihr Gehalt ist daher im allgemeinen so zu wählen, daß die erfindungsgemäßen lichtempfindlichen Gemische nach der Belichtung mit aktinischem Licht in wäßrigen Lösungsmitteln, wie z. B. Wasser oder wäßrigalkalischen Lösungen, löslich oder zumindest dispergierbar sind. Vorzugsweise liegt der Gehalt an aromatischen und/oder heteroaromatischen o-Nitrocarbinolestergruppierungen der in Rede stehenden Art in den Polymeren (a) im Bereich von 10 bis 30 Gew.%, bezogen auf das Molekulargewicht des Polymeren.

Von den weiteren, funktionellen, reaktiven und der thermischen Vernetzung mit der Komponente (b) zugänglichen Gruppen sollen in dem Polymeren (a) wenigstens 2, vorzugsweise aber mehr enthalten sein, um eine hinreichende Vernetzung mit der Komponente (b) zu erzielen. Da durch die Anzahl dieser

weiteren funktionellen, reaktiven Gruppen in dem Polymeren (a) im wesentlichen der in den erfindungsgemäßen lichtempfindlichen härtbaren Gemischen erzielbare Vernetzungs- und Härtungsgrad mitbestimmt wird, ist diese daher gleichfalls im wesentlichen abhängig von den gewünschten und angestrebten Eigenschaften der Endprodukte und kann daher ebenfalls in breiten Grenzen variiert werden. Es hat sich als vorteilhaft erwiesen, wenn die Polymeren (a) 5 bis 50 Gew.%, insbesondere 10 bis 30 Gew.%, der Comonomeren mit diesen funktionellen, reaktiven Gruppen einpolymerisiert enthalten.

Die erfindungsgemäßen lichtempfindlichen härtbaren Gemische können ein oder auch mehrere der Polymeren (a) im allgemeinen in Mengen von 20 bis 85 Gew.%, vorzugsweise von 45 bis 75 Gew.%, bezogen auf das lichtempfindliche härtbare Gemisch, enthalten.

Neben den Polymeren (a) sind in den erfindungsgemäßen lichtempfindlichen, härtbaren Gemischen eine oder mehrere vernetzend wirkende Verbindungen (b) vorhanden, die unter dem Einfluß von Wärme mit den weiteren funktionellen, reaktiven Gruppen des Polymeren (a) zu reagieren vermögen. Um eine gute Lagerstabilität und eine gute Verarbeitbarkeit der erfindungsgemäßen lichtempfindlichen, härtbaren Gemische zu gewährleisten, sind die vernetzend wirkenden Verbindungen (b) so zu wählen, daß sie erst bei erhöhten Temperaturen, d. h. deutliche oberhalb der Raumtemperatur, in merklicher Geschwingkeit mit den weiteren funktionellen, reaktiven Gruppen der Polymeren (a) reagieren. Günstig sind solche vernetzend wirkenden Verbindungen (b), bei denen die thermische Vernetzungsreaktion mit den funktionellen, reaktiven Gruppen des Polymeren (a) bei Temperaturen oberhalb 50 °C, insbesondere bei Temperaturen oberhalb 80 °C, abläuft. Als Komponente (b) geeignete vernetzend wirkende Verbindungen sind beispielsweise solche niedermolekularen und/oder hochmolekularen Verbindungen, die zwei oder mehr Hydroxy-, Amin-, N-Methylolamid-, Amid-, Epoxid- und/oder verkappte Isocyanat-Gruppen im Molekül enthalten. Die als Komponente (b) eingesetzten vernetzend wirkenden Verbindungen sind dabei selbstverständlich auf die funktionellen, reaktiven Gruppen im Polymeren (a) abzustimmen und so zu wählen, daß sie mit diesen in dem Gemisch unter praxisgerechten Bedingungen eine wärmeinduzierte Vernetzungsreaktion eingehen können.

Bevorzugte vernetzend wirkende Verbindungen (b) sind die Di- oder Polyepoxide, welche die Umsetzungsprodukte von Epichlorhydrin mit Polyolen, die Umsetzungsprodukte von Epichlorhydrin mit Polyaminen, Polyolefinepoxide, epoxidiertes Polybutadien, Epoxidharze vom Novolaktyp, Hochpolymere von Glycidylestern umgesättigter Carbonsäuren, insbesondere der (Meth)acrylsäure, und andere umfassen. Von besonderem Interesse sind die Epoxide auf Basis von Epichlorhydrin und Bisphenol A. Durch Substitution des Bisphenol A können die Eigenschaften dieser Epoxide in an sich bekannter Weise beeinflußt werden. Eine andere Gruppe von geeigneten Epoxiden sind diejenigen, in denen die endständigen Glycidylgruppen durch aliphatische oder araliphatische Reste verbunden sind, wofür der Glycidylether des 1,4-Butandiols als typischer Vertreter genannt sein soll. Eine weitere interessante Epoxidverbindung ist das Bis (epoxipropyl)anilin, welches aufgrund seiner äußerst niedrigen Viskosität als bifunktioneller Verdünner eingesetzt werden kann. Unter den hochmolekularen Epoxidverbindungen sind die Epoxidharze vom Novolaktyp und die Polyglycidyl(meth)acrylate aufgrund ihrer hohen Funktionalität von besonderem Interesse. Durch den Einsatz von cycloaliphatischen Epoxiden, die in ihrem Molekül ein oder mehrere cycloaliphatische Ringe, jedoch keine aromatischen Ringe eingebaut enthalten, kann z. B. die UV-Beständigkeit erhöht werden. Bei den cycloaliphatischen Epoxiden kann der Epoxidsauerstoff ausschließlich an die cycloaliphatischen Ringe gebunden sein, wie z. B. im Dicyclopentadiendioxid, er kann ausschließlich in den Seitenketten gebunden sein, wie z. B. beim Diglycidylester der Hexahydrophthalsäure, oder er kann sowohl an den cyclischen Ringen als auch an die Seitenketten gebunden sein, wie z. B. beim Vinylcyclohexandioxid.

Günstig als vernetzend wirkende Verbindung (b) sind auch verkappte Di- oder Polyisocyanate, wobei als schützende Komponente für die Verkappung der Isocyanate hauptsächlich Phenole, Acetonoxim, Methylethylketoxim, Acetessigester oder Malonester in Frage kommen. Für die Verkappung eignen sich jedoch ebenfalls Verbindungen wie Acetylaceton, Phthalimid, Caprolactam, Benzolsulfonamid und 2-Mercapto-benzthiazol. Als Di- oder Polyisocyanate kommen dabei die bekannten aliphatischen, cycloaliphatischen oder aromatischen Verbindungen mit zwei oder mehr Isocyanatgruppen pro Molekül in Betracht, insbesondere bevorzugt Isophorondiisocyanat. Eine gut geeignete, hochwirksame verkappte Isocyanatverbindung erhält man beispielsweise aus 1 Mol Trimethylpropan, 3 Mol 2,4-Diisocyanatotoluol und 3 Mol Phenol. Als weiteres Beispiel für ein verkapptes Isocyanat sei das Isocyanuratderivat genannt, welches durch Trimerisierung des Umsetzungsproduktes von 2,4-Diisocyanatotoluol und Kresol erhalten wird. Ebenfalls hervorragend als vernetzend wirkende Verbindung geeignet sind die aus Toluylendiisocyanat, Trimethylolpropan, Butandiol und Kresol hergestellten verkappten Isocyanate. In die Gruppe von vernetzend wirkenden Verbindungen (b) gehören auch die bekannten Carbodiimide, wie sich durch Carbodiimidisierung von Diisocyanaten entstehen, wie z. B. α,ω-Diisocyanato-Polycarbodiimide aus Isophorondiisocyanat, die ebenfalls als verkappte Polyisocyanate anzusprechen sind.

Als vernetzend wirkende Verbindung (b) sehr gut bewährt haben sich auch Polymere, die Hydroxy-, Amino- und/oder N-Methylol-Gruppen enthalten. Als Beispiele hierfür seien Phenol-Formaldehyd-Harze, Harnstoff-Formaldehyd-Harze und Melamin-Formaldehyd-Harze erwähnt, wobei die Harze vom Novolak-Typ bevorzugt sind.

Hochmolekulare vernetzend wirkende Verbindungen (b) werden in den lichtempfindlichen, härtbaren Gemischen bevorzugt dann verwendet, wenn das lichtempfindliche Polymere (a) ein relativ niedriges

Molekulargewicht besitzt. Sind in den lichtempfindlichen Gemischen o-Nitrocarbinolestergruppierungen tragende Polymere (a) mit hohem Molekulargewicht enthalten, können die vernetzend wirkenden Verbindungen (b) je nach gewünschtem Verwendungszweck und angestrebtem Eigenschaftsbild der lichtempfindlichen Gemische bzw. der hieraus hergestellten Aufzeichnungsmaterialien nieder- oder auch hochmolekular sein.

Als sehr vorteilhaft haben sich solche lichtempfindlichen, härtbaren Gemische erwiesen, in denen die vernetzend wirkende Verbindung (b) ein Di- oder Polyepoxid der genannten Art ist und das o-Nitrocarbinolestergruppierungen tragende Polymere (a) als weitere funktionelle, reaktive Gruppen Hydroxyl-, Amino- und/oder N-Methylolamid-Gruppen eingebaut enthält. In einer anderen vorteilhaften Ausführungsform der Erfindung enthalten die lichtempfindlichen härtbaren Gemische als vernetzend wirkende Verbindung (b) verkappte Di- oder Polyisocyanate und o-Nitrocarbinolestergruppierungen tragende Polymere (a), die als weitere funktionelle, reaktive Gruppen Hydroxyl-, Amino- und/oder N-Methylolamid-Gruppen eingebaut enthalten.

Ebenso bewährt haben sich lichtempfindliche, härtbare Gemische mit Phenol-Formaldehyd-Harzen, Harnstoff-Formaldehyd-Harzen und/oder Melamin-Formaldehyd-Harzen als vernetzenden Verbindungen (b), bei denen das o-Nitrocarbinolestergruppierungen tragende Polymer (a) Amid- oder N-Methylolamid-Gruppen enthält.

Der Gehalt an vernetzend wirkenden Verbindungen (b) in den erfindungsgemäßen lichtempfindlichen, härtbaren Gemischen hängt im wesentlichen von dem im Endprodukt angestrebten und gewünschten Vernetzungs- und Härtungsgrad ab und richtet sich dementsprechend auch nach der Anzahl der in dem o-Nitrocarbinolestergruppierungen tragenden Polymeren (a) enthaltenen weiteren funktionellen, reaktiven Gruppen. Er kann daher, ebenso wie diese, in weiten Grenzen variiert werden. Im allgemeinen liegen die vernetzend wirkenden Verbindungen (b) in dem lichtempfindlichen, härtbaren Gemisch in Mengen von 10 bis 70 Gew.%, vorzugsweise von 20 bis 50 Gew.%, bezogen auf das Polymer (a), vor.

Als weiteren wesentlichen Bestandteil enthalten die erfindungsgemäßen lichtempfindlichen Gemische einen oder mehrere Füllstoffe (c), üblicherweise in Mengen von 0,5 bis 8 Gew.%, vorzugsweise in Mengen von 2 bis 5 Gew.%, bezogen auf das gesamte lichtempfindliche, härtbare Gemisch. Die Füllstoffe verbessern nicht nur die mechanischen Eigenschaften der lichtempfindlichen, härtbaren Gemische bzw. der hieraus hergestellten Aufzeichnungsmaterialien, z. B. Steifigkeit etc., sondern sie verhindern insbesondere auch ein unerwünschtes Verfließen der aus den lichtempfindlichen, härtbaren Gemischen hergestellten Schichten bei der thermischen Härtung und sind maßgebend für die mit diesen Schichten erzielbare hohe Auflösung bei der Herstellung von Reliefformen, Resistmustern, Lötstopp-Masken etc. Ferner bewirken die Füllstoffe hierbei die Ausbildung scharfer und exakter Bildkonturen und Reliefstrukturen mit steilen Flanken. Als Füllstoffe kommen z. B. in Frage : Talkum, Calciumcarbonat, Siliciumdioxide wie z. B. Quarzmehl, amorphe Kieselsäure, pyrogene Kieselsäure, Silikate wie z. B. Aluminiumsilikate, Silikatgläser, Aluminiumoxide, Glaspulver oder Glasstaub, Benthonite etc. Die Füllstoffe sind selbstverständlich so auszuwählen, daß sie die optischen Eigenschaften der lichtempfindlichen, härtbaren Gemische, insbesondere ihre Transparenz im Wellenlängenbereich des für diese Gemische aktinischen Lichtes, nicht beeinträchtigen. Die mittlere Teilchengröße dieser Füllstoffe liegt im allgemeinen im Bereich von 5 bis 100 nm, vorzugsweise im Bereich von 10 bis 50 nm.

Darüber hinaus können die erfindungsgemäßen lichtempfindlichen, härtbaren Gemische weitere übliche und an sich bekannte Zusatz- und/oder Hilfsstoffe enthalten. Hierbei kann es sich einerseits um Verbindungen handeln, die die Verarbeitung und Handhabung der lichtempfindlichen, härtbaren Gemische erleichtern, wie z. B. Weichmacher oder Verlaufsmittel, oder auch um solche Zusatzstoffe, die die anwendungstechnischen Eigenschaften dieser Gemische bzw. der hieraus hergestellten Aufzeichnungsmaterialien verbessern oder modifizieren, wie z. B. Sensibilisatoren, die die Lichtempfindlichkeit und die spektrale Empfindlichkeit erhöhen, Farbstoffe, Pigmente und/oder photochrome Substanzen, sensitometrische Regler, Katalysatoren für die thermische Härtungs- und Vernetzungsreaktion, gegebenenfalls weitere polymere Bindemittel, die mit den o-Nitrocarbinolestergruppierungen tragenden Polymeren (a) verträglich sind, und ähnliche. Diese Hilfs- und/oder Zusatzstoffe können in den für diese Verbindungen an sich bekannten und üblichen Mengen eingesetzt werden.

Beispiele für weichmachende Verbindungen, die insbesondere dann zugesetzt werden, wenn die lichtempfindlichen härtbaren Gemische aus der Schmelzmischung heraus zu Schichten verarbeitet bzw. durch Laminieren auf ein Trägermaterial aufgebracht werden sollen und die mit dem die o-Nitrocarbinolestergruppierungen tragenden Polymeren (a) verträglich sein sollen, sind Trikresylphosphat, n-Butyl-Benzyl-phthalat und flüssige Polyester aus aliphatischen Dicarbonsäuren und bifunktionellen Glykolen, insbesondere Polyester aus Adipinsäure und 1,2-Propylenglykol oder 1,4-Butandiol mit einer Viskosität von 1 000 bis 15 000 cP. Sind in den lichtempfindlichen, härtbaren Gemischen als vernetzend wirkende Verbindungen (b) niedermolekulare Verbindungen enthalten, so können diese auch als Weichmacher wirken und den Zusatz von gesonderten weichmachenden Verbindungen teilweise oder vollständig überflüssig machen. Verlaufsmittel, wie z. B. Silikonöle, sind insbesondere dann empfehlenswert, wenn die lichtempfindlichen, härtbaren Gemische durch Gießen aus Lösung weiterverarbeitet werden sollen.

Beispiele für Sensibilisatoren, durch die die Lichtempfindlichkeit und die spektrale Empfindlichkeit der lichtempfindlichen, härtbaren Gemische verbessert werden können, sind Xanthen-Farbstoffe, wie

Fluorescein, Eosin und Rodamin (S) sowie Triplett-Energieüberträger, wie sie beispielsweise N.J. Turro in seinem Buch « Molecular Photochemistry », W.A. Benjamin Inc., New York, 1967, auf Seite 132 beschreibt. Als Farbstoffe haben sich unter anderem Sudanfarbstoffe, Polymethinfarbstoffe, Azofarbstoffe, Phthalocyanin-Farbstoffe oder Dispersionsfarbstoffe sowie Eosin, Kristallviolett oder Malachitgrün bewährt. Besonders vorteilhaft sind solche Farbstoffe, die bei der Belichtung mit aktinischem Licht ihre Färbung reversibel oder irreversibel ändern. So werden z. B. Sudanfarbstoffe, Polymethinfarbstoffe oder Azofarbstoffe durch zugesetzte Photoinitiatoren, wie Benzoinether, Benzilketale, Benzophenon oder Michlers Keton bei Belichtung mit aktinischem Licht ausgebleicht. Gut bewährt haben sich Polymethinfarbstoffe der allgemeinen Formel (II)

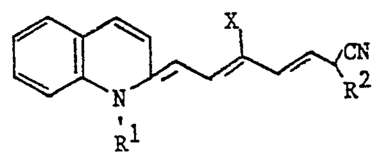

(II)

worin stehen $R^1$ für einen Alkyl-Rest, $R^2$ für —CN, —$COOR^3$ oder —Ph—$R^4$ ; $R^3$ für einen Alkyl-Rest ; $R^4$ für —$NO_2$, Halogen, Alkyl oder Alkoxy ; und X für ein Halogenatom.

Je nach Art der in den erfindungsgemäßen lichtempfindlichen Gemischen enthaltenen vernetzend wirkenden Verbindungen (b) sowie der weiteren funktionellen, reaktiven Gruppen in den die o-Nitrocarbinolestergruppierungen tragenden Polymeren (a) kann es sinnvoll und nützlich sein, wenn in den lichtempfindlichen, härtbaren Gemischen Katalysatoren für die thermische Härtung und Vernetzung zwischen der Komponente (b) und den weiteren funktionellen Gruppen des Polymeren (a) enthalten sind. Während beispielsweise die Reaktion zwischen Harnstoff- oder Melamin-Formaldehyd-Harzen und Amid-Gruppen bzw. die Reaktion zwischen verkappten Isocyanaten — je nach Art des eingesetzten verkappten Isocyanats — und Hydroxyl- oder Amin-Gruppen bereits im allgemeinen im Temperaturbereich von 80 bis 150 °C abläuft, sind für die Anlagerung von Epoxidgruppen an Hydroxylgruppen Härtungstemperaturen erforderlich, die bei 200 °C oder höher liegen. Will man daher auch in diesen Fällen bei niedrigeren Härtungstemperaturen arbeiten, empfiehlt sich der Zusatz von geeigneten Katalysatoren. Die Katalysatoren werden dabei insbesondere so ausgewählt, daß sie erst bei höheren Temperaturen, vorzugsweise bei Temperaturen über 50 °C, und insbesondere über 70 °C, wirksam werden und die thermische Härtungs- und Vernetzungsreaktion zwischen den Komponenten (a) und (b) möglichst bei Temperaturen bis 150 °C, vorzugsweise bis 130 °C, ablaufen lassen. Geeignete Katalysatoren sind z. B. Dicyandiamid, Melamin-Formaldehyd-Harze und Komplexe von Aminen, die erst bei höheren Temperaturen spalten, wie z. B. der Komplex aus Bortrifluorid und Ethylamin. Ferner kommen thermisch aktivierbare, kationische Systeme in Frage, wie z. B. Iodonium-, Phosphonium- oder Sulfoniumsalze, wie sie z. B. in der DE-A-3 139 520 und der DE-A-2 854 011 beschrieben sind. Die Katalysatoren sind in den lichtempfindlichen, härtbaren Gemischen vorzugsweise in Mengen von 1 bis 5 Gew.%, bezogen auf das gesamte lichtempfindliche, härtbare Gemisch, enthalten.

Die erfindungsgemäßen lichtempfindlichen, härtbaren Gemische sind im allgemeinen fest, trocken und nicht klebrig. Sie können hergestellt werden durch homogenes Vermischen der einzelnen Bestandteile, z. B. in Knetern, Mischern oder dergleichen, oder auch als Lösung in geeigneten Lösungsmitteln, wie z. B. Aceton, Essigsäureethylester, Toluol oder Methylenchlorid. Sie eignen sich besonders vorteilhaft als positiv arbeitende Aufzeichnungsmaterialien für die optische Informationsfixierung, wie z. B. für die Herstellung von Druck- und Reliefformen, Reliefbildern oder Resistmustern, insbesondere Lötstoppmasken. Unter « positiv arbeitend » werden dabei solche Aufzeichnungsmaterialien verstanden, bei denen nach einer bildmäßigen Belichtung mit aktinischem Licht die belichteten Bereiche in Lösungsmitteln löslich werden, in denen sie vorher unlöslich waren.

Zur Herstellung von entsprechenden lichtempfindlichen Aufzeichnungsmaterialien können die erfindungsgemäßen lichtempfindlichen, härtbaren Gemische in Schichten der gewünschten Dicke auf geeignete Trägermaterialien aufgebracht werden. Die Wahl des Trägers richtet sich vornehmlich nach dem Anwendungszweck der Aufzeichnungsmaterialien und der damit herzustellenden Reliefbilder oder Resistmuster. Als dimensionsstabile Trägermaterialien kommen beispielsweise metallische, metalloxidische oder keramische Untergründe, aber auch Filme, Folien oder Platten aus polymeren Substanzen in Betracht. So können beispielsweise für die Herstellung von Resistmustern Kupferbleche oder kupferkaschierte Substrate als Trägermaterialien dienen. Bei der Herstellung von Dünnschichtschaltungen werden als Trägermaterial insbesondere Keramiksubstrate, die mit metallischen oder metalloxidischen Schichten beschichtet sind, oder Halbleiterelemente verarbeitet. Zur Herstellung von Reliefbildern und Druckplatten, sowie insbesondere von Offset-Druckplatten, können als Träger Kunststoff-Folien, z. B. aus Polyestern, oder Metallträger, z. B. Stahl- oder Aluminium-Bleche, eingesetzt werden. Insbesondere für die Herstellung von Offset-Druckplatten können die Kunststoff-Folien auch metallisch bedampft sein und die Stahl- oder Aluminium-Bleche mechanisch oder elektrochemisch aufgerauht sein und/oder eine anodisch erzeugte Oxidschicht besitzen. Für die besonders bevorzugte Anwendung zur Herstellung von Lötstoppmasken können Schichten der lichtempfindlichen härtbaren Gemische auf das Schaltbild einer gedruckten Schaltung als Träger aufgebracht werden.

Das Aufbringen der Schichten aus den lichtempfindlichen, härtbaren Gemischen auf die Trägermaterialien kann nach den bekannten und üblichen Techniken erfolgen, beispielsweise indem man Lösungen der lichtempfindlichen, härtbaren Gemische durch spin-coating, Rasterwalzenauftrag, Tauchbeschichtung, Vorhanggießen, Lippengießen oder andere ähnliche Verfahren in geeigneter Schichtdicke auf das Trägermaterial aufbringt, das Lösungsmittel verdampft und die lichtempfindliche Schicht bei Temperaturen trocknet, bei denen noch keine thermische Vernetzung und Härtung staffdindet. Man kann die lichtempfindlichen, härtbaren Gemische jedoch beispielsweise auch durch Pressen oder Kalandrieren zu einer lichtempfindlichen Schicht formen und diese anschließend auf die Trägermaterialien unter Anwendung von Druck sowie gegebenenfalls Wärme auflaminieren, wobei auch hierbei die Verarbeitungstemperaturen so zu wählen sind, daß sie unter den Temperaturen für die thermische Vernetzung und Härtung der lichtempfindlichen, härtbaren Gemische liegen. Gemäß einer sehr vorteilhaften Ausführungsform wird aus den lichtempfindlichen, härtbaren Gemischen zunächst eine lichtempfindliche Schicht auf einem temporären Träger, insbesondere einer Kunststoff-Folie, z. B. aus Polyethylenterephthalat, beispielsweise durch Gießen aus Lösung, hergestellt. Mittels eines solchen Schichtübertragungsmaterials läßt sich dann die lichtempfindliche Schicht aus den erfindungsgemäßen Gemischen auf die permanenten Trägermaterialien unter Anwendung von Druck sowie gegebenenfalls Wärme auflaminieren. Ein besonderer Vorteil dieser trockenen Schichtübertragung zur Herstellung der Aufzeichnungsmaterialien liegt darin, daß man die lichtempfindliche Schicht vor dem Aufbringen auf den permanenten Träger kurzzeitig vollflächig mit aktinischem Licht vorbelichten kann. Diese Vorbelichtung geschieht bevorzugt von der Seite der lichtempfindlichen Schicht her, die später auf den permanenten Träger aufgebracht wird. Diese Vorbelichtung führt nicht nur zu einer verbesserten Haftung der lichtempfindlichen Schicht auf dem permanenten Träger, insbesondere metallischen oder metalloxidischen Untergründen, sondern auch zu einer Erhöhung der Lichtempfindlichkeit dieser Schicht bei der bildmäßigen Belichtung und zu einer Verringerung der Entwicklungszeit nach der bildmäßigen Belichtung, ohne daß hierdurch etwa die originalgetreue und exakte Wiedergabe des übertragenen Bildes bei der optischen Informationsfixierung in irgendeiner Weise nachteilig beeinflußt wird.

Die Dicke der lichtempfindlichen Schichten der erfindungsgemäßen Aufzeichnungsmaterialien kann je nach gewünschtem Anwendungszweck im Bereich von 0,5 µm bis einigen Millimetern, vorzugsweise bis etwa 1 mm, liegen.

Die erfindungsgemäßen Aufzeichnungsmaterialien eignen sich insbesondere zur Herstellung von temperaturstabilen, permanenten Druck- und Reliefformen und insbesondere permanenten, bildmäßig strukturierten Schutz- und Isolierschichten, wie u.a. Lötstoppmasken. Zur Herstellung der Reliefbilder, Reliefformen oder Resistmuster wird die lichtempfindliche Schicht der Aufzeichnungsmaterialien durch eine photographische Bildvorlage mit aktinischem Licht, vorzugsweise im Wellenlängenbereich von 220 bis 600 nm, insbesondere von 300 bis 420 nm, belichtet. Als Lichtquellen können z. B. Kohlebogenlampen, Quecksilberhochdrucklampen, Xenonhochdrucklampen und insbesondere Quecksilberniederdruckfluoreszenzlampen dienen. Die bildmäßige Belichtung kann auch mit einem bildmäßig modulierten aktinischem Laserstrahl, z. B. einem UV-Laser, erfolgen. Die Belichtungszeiten für die bildmäßige Belichtung liegen im allgemeinen im Bereich von 30 sek bis einigen Minuten. Nach der bildmäßigen Belichtung werden die belichteten Schichtanteile mit einem wäßrigen Entwickler-Lösungsmittel in üblicher Weise, beispielsweise durch Besprühen, Ausreiben oder Ausbürsten, ausgewaschen. Bei den wäßrigen Entwickler-Lösungsmitteln kann es sich um Wasser als solches oder auch um Mischungen von Wasser mit wasserlöslichen, organischen Lösungsmitteln handeln, beispielsweise um Gemische von Wasser mit aliphatischen Alkoholen, Aceton oder Tetrahydrofuran. Zur Einstellung des günstigsten pH-Wertes können den Entwickler-Lösungsmitteln auch Alkalien, wie z. B. Borax, Dinatriumhydrogenphosphat, Soda oder Alkalihydroxide, oder organische Basen, wie Di- oder Triethanolamin, zugesetzt werden. Ferner können die Auswaschlösungen auch Zusätze von oberflächenaktiven Substanzen, z. B. Natriumcarboximethylcellulose, Polyvinylalkohol, Polynatriumacrylat und dergleichen, enthalten.

Bei der Herstellung von Lötstoppmasken, bei der die lichtempfindliche Schicht aus den erfindungsgemäßen Gemischen auf die zu verarbeitende Oberfläche, z. B. auf das mit Leiterzügen und Bohrlöchern versehene Schaltbild, einer Leiterplatte aufgebracht wird, werden durch die bildmäßige Belichtung und Entwicklung der Schicht die Lötaugen freigelegt. In diesen Fällen kann die Belichtung der lichtempfindlichen Schicht an den Stellen der freizulegenden Lötaugen sowohl durch eine Photomaske erfolgen, sie kann jedoch auch ohne Verwendung eines besonderen Maskenfilms derart vorgenommen werden, daß die gelochte Leiterplatte die Funktion der Photomaske übernimmt. Hierzu wird die auf die gelochte Leiterplatte aufgebrachte lichtempfindliche Schicht von der Gegenseite her durch die Löcher der Leiterplatte belichtet. Vorteilhafterweise wird dabei auf die freie, von der Leiterplatte abgewandte Oberfläche der lichtempfindlichen, härtbaren Schicht eine Streufolie oder ein Spiegel, z. B. eine feingebürstete Aluminiumplatte, gelegt, insbesondere wenn die verwendete Lichtquelle einen hohen Anteil an nicht-parallelem Licht besitzt. Hierdurch wird erreicht, daß die lichtempfindliche Resistschicht im Lochbereich gleichmäßiger ausgeleuchtet wird und somit die Löcher in der Resistschicht exakt abgebildet werden. Bei dieser Verfahrensvariante werden in der lichtempfindlichen Schicht nur die Bereiche der Löcher entfernt, so daß die Lötaugen, d. h. die leitfähigen Höfe um das Loch, weiterhin geschützt sind. Dies ist auf der Bestückungsseite der Leiterplatte erwünscht oder auch, wenn lötfreie Bestückungsverfahren, z. B. mittels Steckkontakten, angewandt werden. Im letztgenannten Fall ist die

filmlose Verfahrensvariante auch auf beiden Seiten der Leiterplatte einsetzbar.

Nach dem Entfernen der belichteten Schichtanteile wird der auf dem Träger verbliebene Teil der lichtempfindlichen Schicht, d. h. das nunmehr bereits erzeugte Reliefbild oder Resistmuster, durch die thermische Vernetzungsreaktion zwischen den Komponenten (a) und (b) gehärtet. Hierzu wird die Schicht soweit erhitzt, daß die Reaktion zwischen den Komponenten (a) und (b) abläuft. Im allgemeinen sind hierzu Temperaturen im Bereich von 70 bis 200 °C, vorzugsweise im Bereich von 80 bis 150 °C, erforderlich. Die Dauer der thermischen Härtung liegt im allgemeinen im Bereich von 20 bis 120 min. Die thermische Härtung kann entweder durch Beaufschlagen der Schicht mit warmer Luft, beispielsweise in einem Ofen, oder durch Erhitzen der Schicht mit Infrarotstrahlung erfolgen. Durch diese nachfolgende thermische Härtung und Vernetzung wird die Stabilität der Schicht, insbesondere bezüglich der chemischen und mechanischen Resistenz, erheblich verbessert, ohne daß bei dieser Temperaturbehandlung die Reliefstrukturen unscharf werden und beispielsweise bei der Herstellung von Lötstoppmasken die Schicht in die Lötaugen hineinfließt.

Nach der thermischen Härtung und Vernetzung besitzen die hergestellten Reliefbilder oder Resistmuster sehr gute Resistenz gegen Chemikalien und Lösungsmittel, eine hohe Temperaturbeständigkeit, so daß sie beispielsweise Temperaturbelastungen bis zu 260 °C bei Belastungszeiten von mehr als 15 sec. ohne erkennbare Beeinträchtigung aushalten. Die Reliefstruktur ist vorlagengetreu und scharfkantig ausgebildet ; die Reliefbilder und Resistmuster besitzen ausgezeichnete elektrische Werte bezüglich Durchgangswiderstand, Oberflächenwiderstand, Durchschlagsfestigkeit und Dielektrizitätszahl.

Die Erfindung wird durch die nachfolgenden Beispiele näher erläutert. Die in den Beispielen genannten Teile und Prozente beziehen sich, sofern nicht anders angegeben, auf das Gewicht.

## Beispiel 1

50 Teile eines Copolymerisats aus 20 % o-Nitrobenzylacrylat, 70 % Methylmethacrylat und 10 % Hydroxypropylacrylat (hergestellt durch radikalische Polymerisation der Monomeren mit Azodiisobutyronitril in Essigester ; K-Wert des Polymeren : 28), 25 Teile eines Bisphenol A-Diglycidylethers (®Epikote 828 der Fa. Shell), 25 Teile n-Butyl-benzyl-phthalat, 3 Teile Bortrifluorid-ethylamin-Komplex, 1 Teil Benzildimethylketal, 0,1 Teile des Farbstoffes Sudantiefschwarz BB, 0,2 Teile des Polymethinfarbstoffes der Formel (II), worin $R^1$ = Methyl und $R^2$ = —COOEt und X = Cl ist und 3 Teile einer pyrogenen Kieselsäure wurden in 150 Vol.-Teilen Essigsäureethylester gelöst, wobei die Kieselsäure vor der Zugabe in Essigester dispergiert und dann als Dispersion zugegeben wurde.

Aus dieser Lösung wurde auf eine Polyesterfolie eine lichtempfindliche Schicht so gegossen, daß nach Entfernung des Lösungsmittels und Trocknung eine Schichtdicke von etwa 50 µm resultierte. Das so erhaltene Schichtübertragungsmaterial wurde mit der freien Oberfläche der lichtempfindlichen Schicht bei einer Temperatur von 120 °C mit einer Geschwindigkeit von 0,5 m/min auf eine gedruckte Schaltung auflaminiert. Nach Abziehen der Polyesterfolie wurde die lichtempfindliche Schicht durch eine photographische Positiv-Vorlage 4 min mit einem Flachbelichter (5000 W) bildmäßig belichtet. Die belichteten, entfärbten Schichtanteile wurden mit einem Gemisch aus 85 % Wasser, 12 % 2-Butoxiethanol und 3 % Triethanolamin 20 min lang ausgewaschen. Das so erhaltene vorlagengetreue und scharfkantige Resistmuster wurde durch Abblasen mit Druckluft von Resten des Entwicklerlösungsmittels befreit und anschließend 2 Stunden in einem Umluftofen bei 150 °C gehärtet. Der erhaltene Resist hatte eine sehr hohe thermische Beständigkeit, eine ausgezeichnete Haftung auf der als Träger dienenden gedruckten Schaltung und zeigte selbst feine Bildelemente vorlagensgetreu und mit scharfen Konturen. Der erhaltene Resist konnte hervorragend als Lötstoppmaske verwendet werden.

## Beispiel 2

Es wurde wie in Beispiel 1 verfahren mit dem Unterschied, daß die lichtempfindliche Schicht vor dem Auflaminieren auf die gedruckte Schaltung von ihrer freien Oberfläche her 30 sec lang vollflächig mit dem gleichen Flachbelichter, wie er zu der bildmäßigen Belichtung benutzt wurde, vorbelichtet wurde, Hierdurch konnte die Belichtungszeit der bildmäßigen Belichtung auf 2 min verkürzt werden. Es wurde ein Produkt mit gleichguten Eigenschaften wie im Beispiel 1 erhalten.

## Beispiel 3

Es wurde wie in Beispiel 1 ein Schichtübertragungsmaterial hergestellt und auf eine gedruckte Schaltung auflaminiert. Nach Abziehen der Polyester-Folie wurde auf die freie Oberfläche der lichtempfindlichen Schicht eine feingebürstete Aluminiumplatte aufgelegt und die lichtempfindliche Schicht von der Gegenseite durch die Bohrlöcher der gedrukten Schaltung hindurch mit einer 500 W Höchstdruck-Quecksilberlampe 15 min belichtet. Danach wurde die lichtempfindliche Schicht wie in Beispiel 1 beschrieben entwickelt, getrocknet und gehärtet. Man erhielt eine Lötstoppmaske, bei der die Löcher der gedruckten Schaltung freigelegt waren, die leitfähigen Höfe um die Lötangen herum jedoch geschützt blieben.

Beispiel 4

Eine Lösung aus 60 Teilen eines Copolymerisats aus 20 % o-Nitrobenzylacrylat, 69 % Methylmethacrylat, 10 % Hydroxypropylacrylat und 1 % Acrylsäure, 30 Teilen n-Butyl-benzyl-phthalat, 10 Teilen eines mit Methylethylketoxim verkappten Isophorondiisocyanats, 1 Teil Benzildimethylketal, 0,1 Teilen Sudantiefschwarz BB, 0,2 Teilen des Polymethinfarbstoffes von Beispiel 1 und 3 Teilen einer pyrogenen Kieselsäure in 150 Vol.-Teilen Essigsäureethylester wurde wie in Beispiel 1 beschrieben zu einer lichtempfindlichen Schicht gegossen und diese wie in Beispiel 1 beschrieben zu einer Lötstoppmaske weiterverarbeitet. Die Belichtungszeit für die bildmäßige Belichtung betrug in diesem Fall 2 min. Es wurde ein Produkt erhalten, welches in seinen Eigenschaften dem von Beispiel 1 entsprach.

Beispiel 5

Durch Lösen in 150 Vol.-Teilen Essigsäureethylester wurde ein lichtempfindliches, härtbares Gemisch aus 50 Teilen eines Copolymerisats aus 20 % o-Nitrobenzylacrylat, 70 % Methylmethacrylat und 10 % Acrylamid, 15 Teilen eines Melamin-Formaldehyd-Harzes, 35 Teilen n-Butyl-benzyl-phthalat, 3 Teilen einer pyrogenen Kieselsäure, 1 Teil Benzildimethylketal, 0,1 Teil des Farbstoffes Sudantiefschwarz BB sowie 0,2 Teile des Polymethinfarbstoffes von Beispiel 1 hergestellt. Aus dieser Lösung wurde wie in Beispiel 1 auf eine Polyesterfolie eine lichtempfindliche Schicht gegossen und auf eine gedruckte Schaltung auflaminiert. Nach bildmäßiger Belichtung und Entwicklung der Schicht wurde 1 Stunde bei 130 °C gehärtet. Das erhaltene Produkt war hervorragend als Lötstoppmaske geeignet.

Beispiel 6

Es wurde eine Lösung aus 50 Teilen eines Copolymerisats aus 25 % o-Nitrobenzylacrylat, 70 % Methylmethacrylat und 5 % Glycidylmethacrylat, 25 Teilen des Bisphenol A-Diglycidylethers von Beispiel 1, 28 Teilen n-Butylbenzyl-phthalat, 3 Teilen 1-Cyanguanidin, 3 Teilen Kieselerde, 0,1 Teilen Sudantiefschwarz BB, 0,2 Teilen des Polymethinfarbstoffes von Beispiel 1 und 1 Teil Benzildimethylketal in 150 Vol.-Teilen Essigsäureethylester hergestellt. Hieraus wurde, wie in Beispiel 1 beschrieben, ein thermisch gehärtetes Resistmuster mit hoher Auflösung und scharfen Konturen hergestellt. Die Belichtungszeit für die bildmäßige Belichtung betrug diesmal 6 Minuten.

Beispiel 7

Durch Lösen in 150 Vol.-Teilen Essigsäureethylester wurde eine lichtempfindliche Mischung aus folgenden Bestandteilen hergestellt : 80 Teilen eines Copolymerisats aus 25 % o-Nitrobenzylacrylat, 70 % Methylmethacrylat und 5 % N-Methylolacrylamid, 10 Teilen eines Melamin-Formaldehyd-Harzes, 30 Teilen n-Butyl-benzyl-phthalat, 1 Teil Benzildimethylketal, 0,1 Teilen Sudantiefschwarz BB, 0,2 Teilen des Polymethinfarbstoffes von Beispiel 1 sowie 3 Teilen pyrogener Kieselsäure. Hieraus wurde, wie in Beispiel 1 beschrieben, eine Lötstoppmaske mit sehr guten anwendungstechnischen Eigenschaften hergestellt.

**Patentansprüche**

1. Als positiv arbeitendes Aufzeichnungsmaterial geeignetes lichtempfindliches, härtbares Gemisch von

(a) mindestens einem Polymeren mit einem Molekulargewicht > 500, wobei das Polymere (a) ein Copolymerisat aus mit aromatischen und/oder heteroaromatischen o-Nitrocarbinolen veresterten olefinisch ungesättigten Carbonsäuren, weitere funktionelle, reaktive Gruppen enthaltenden olefinisch ungesättigten Monomeren sowie gegebenenfalls weiteren Comonomeren ist, welches mindestens 5 Gew.%, bezogen auf das Molekulargewicht des Polymeren (a), an aromatischen und/oder heteroaromatischen o-Nitrocarbinolestergruppierungen und zusätzlich mindestens zwei weitere funktionelle, der Reaktion mit einem thermischen Vernetzer zugängliche, reaktive Gruppen, ausgewählt aus Hydroxyl-, Amin-, Amid-, N-Methylolamid-, Epoxid- und/oder verkappte Isocyanat-Gruppen, eingebaut enthält,

(b) mindestens einer vernetzend wirkenden Verbindung, ausgewählt aus niedermolekularen oder hochmolekularen Verbindungen mit mindestens zwei Epoxid-, verkappten Isocyanat-, Amid-, N-Methylolamid-, Hydroxyl- und/oder Amin-Gruppen, die unter dem Einfluß von Wärme bei Temperaturen deutlich oberhalb Raumtemperatur mit den weiteren funktionellen, reaktiven Gruppen des Polymeren (a) zu reagieren vermag,

(c) einem Füllstoff sowie gegebenenfalls

(d) weiteren üblichen Zusatz- und/oder Hilfsstoffen.

2. Lichtempfindliches Gemisch gemäß Anspruch 1, dadurch gekennzeichnet, daß das Polymere (a)

als weitere funktionelle Gruppen Hydroxyl-, Amin- oder N-Methylolamid-Gruppen eingebaut enthält und die vernetzend wirkende Verbindung (b) ein Di- oder Polyepoxid ist.

3. Lichtempfindliches Gemisch gemäß Anspruch 1, dadurch gekennzeichnet, daß das Polymere (a) als weitere funktionelle Gruppen Hydroxyl-, Amin- oder N-Methylolamid-Gruppen eingebaut enthält und die vernetzend wirkende Verbindung (b) ein verkapptes Di- oder Polyisocyanat ist.

4. Lichtempfindliches Gemisch gemäß Anspruch 1, dadurch gekennzeichnet, daß das Polymere (a) als weitere funktionelle reaktive Gruppen Amid- oder N-Methylolamid-Gruppen eingebaut enthält und die vernetzend wirkende Verbindung (b) ein Melamin-Formaldehyd-Harz, Harnstoff-Formaldehyd-Harz oder Phenol-Formaldehyd-Harz ist.

5. Lichtempfindliches Gemisch nach einem der vorhergehenden Ansprüche, insbesondere gemäß Anspruch 2, dadurch gekennzeichnet, daß es thermisch aktivierbare Katalysatoren für die thermische Härtung und Vernetzung der Komponenten (a) und (b) enthält.

6. Lichtempfindliches Gemisch gemäß einem der Ansprüche 1 bis 5, dadurch gekennzeichnet, daß das Polymere (a) ein Copolymerisat aus mit aromatischen und/oder heteroaromatischen o-Nitrocarbinolen veresterter (Meth)acrylsäure, die weiteren funktionellen Gruppen tragenden Acryl- oder Methacrylverbindungen sowie gegebenenfalls weiteren Comonomeren, insbesondere (Meth)acrylaten, ist.

7. Positiv arbeitendes Aufzeichnungsmaterial, insbesondere zur Herstellung von temperaturstabilen Reliefbildern, Reliefformen oder Resistmustern, mit einer auf einem dimensionsstabilen Träger aufgebrachten lichtempfindlichen, härtbaren Schicht, dadurch gekennzeichnet, daß die lichtempfindliche, härtbare Schicht aus einem Gemisch gemäß einem der Ansprüche 1 bis 6 gebildet wird.

8. Verwendung der lichtempfindlichen Gemische gemäß einem der Ansprüche 1 bis 6 zur Herstellung von Reliefbildern, Reliefformen oder Resistmustern, insbesondere zur Herstellung von Lötstoppmasken.

**Claims**

1. A curable photosensitive mixture which is suitable as a positive-working recording material and contains

(a) at least one polymer which has a molecular weight of > 500, polymer (a) being a copolymer of olefinically unsaturated carboxylic acids esterified with aromatic and/or heteroaromatic o-nitrocarbinols ; olefinically unsaturated monomers containing further reactive functional groups ; and, if desired, other comonomers, and which contains at least 5 % by weight, based on the molecular weight of polymer (a), of aromatic and/or heteroaromatic o-nitrocarbinol ester groups and also contains at least two further reactive functional groups, selected from hydroxyl, amine, amide, N-methylolamide, epoxide and/or blocked isocyanate groups, which are available for reaction with a thermal cross-linking agent,

(b) at least one compound, selected from low molecular weight or high molecular weight compounds containing at least two epoxide, blocked isocyanate, amide, N-methylolamide, hydroxyl and/or amine groups, which effects crosslinking and is capable of reacting with the further reactive functional groups of polymer (a) under the action of heat, at temperatures substantially above room temperature,

(c) a filler and, if desired,

(d) further conventional additives and/or auxiliaries.

2. A photosensitive mixture as claimed in claim 1, wherein polymer (a) contains, as further functional groups, hydroxyl, amine or N-methylolamide groups, and compound (b) which effects crosslinking is a di- or polyepoxide.

3. A photosensitive mixture as claimed in claim 1, wherein polymer (a) contains, as further functional groups, hydroxyl, amine or N-methylolamide groups, and compound (b) which effects crosslinking is a blocked di- or polyisocyanate.

4. A photosensitive mixture as claimed in claim 1, wherein polymer (a) contains, as further reactive functional groups, amide or N-methylolamide groups, and compound (b) which effects crosslinking is a melamine/formaldehyde resin, a urea/formaldehyde resin or a phenol/formaldehyde resin.

5. A photosensitive mixture as claimed in any of the preceding claims, particularly claim 2, containing a thermally activatable catalyst for the thermal curing and crosslinking of components (a) and (b).

6. A photosensitive mixture as claimed in any of claims 1 to 5, wherein polymer (a) is a copolymer of acrylic or methacrylic acid esterified with aromatic and/or heteroaromatic o-nitrocarbinols ; acrylyl or methacrylyl compounds containing the further functional groups ; and, if desired, other comonomers, particularly acrylates or methacrylates.

7. A positive-working recording material, in particular for the production of thermally stable relief images, relief plates or resist patterns, comprising a curable photosensitive layer applied to a dimensionally stable base, wherein the curable photosensitive layer consists of a mixture as claimed in any of claims 1 to 6.

8. The use of a photosensitive mixture as claimed in any of claims 1 to 6 for the production of relief images, relief plates or resist patterns and especially for the production of solder masks.

**Revendications**

1. Mélange durcissable, sensible à la lumière, convenant comme matière d'enregistrement travaillant positivement, et comprenant

(a) au moins un polymère d'un poids moléculaire > 500 le polymère (a) étant un copolymérisat d'acides carboxyliques insaturés oléfiniquement, estérifiés avec des o-nitrocarbinols aromatiques et/ou hétéroaromatiques, d'autres monomères insaturés oléfiniquement contenant des groupes réactifs fonctionnels ainsi qu'éventuellement d'autres comonomères, qui contient, incorporé, au moins 5 % en poids, rapporté au poids moléculaire du polymère (a) de groupements d'ester d'o-nitrocarbinol aromatiques et/ou hétéroaromatiques, et additionnellement au moins deux autres groupes réactifs acceptables pour la réaction avec un réticulant thermique et choisis parmi les groupes hydroxyle, amine, amide, N-méthylolamide, époxyde et/ou isocyanate masqués,

(b) au moins un composé à effet réticulant choisi parmi les composés à bas poids moléculaire ou à poids moléculaire élevé ayant au moins deux groupes époxyde, isocyanate masqués, amide, N-méthylolamide, hydroxyle et/ou amine, qui, sous l'influence de la chaleur, à des températures nettement supérieures à la température ordinaire, peuvent réagir avec les autres groupes réactifs fonctionnels du polymère (a),

(c) une charge ainsi qu'éventuellement

(d) d'autres additifs et/ou auxiliaires usuels.

2. Mélange sensible à la lumière selon la revendication 1, caractérisé par le fait que le polymère (a) contient, incorporé, comme autres groupes fonctionnels, des groupes hydroxyle, amine ou N-méthylolamide et le composé à effet réticulant (b) est un di- ou polyépoxyde.

3. Mélange sensible à la lumière selon la revendication 1, caractérisé par le fait que le polymère (a) contient, incorporé, comme autres groupes fonctionnels, des groupes hydroxyle, amine ou N-méthylolamide et le composé à effet réticulant (b) est un di- ou polyisocyanate.

4. Mélange sensible à la lumière selon la revendication 1, caractérisé par le fait que le polymère (a) contient, incorporé, comme autres groupes réactifs fonctionnels, des groupes amide ou N-méthylolamide et le composé à effet réticulant (b) est une résine mélamine-formaldéhyde, résine urée-formaldéhyde ou résine phénol-formaldéhyde.

5. Mélange sensible à la lumière selon l'une des revendications précédentes, en particulier selon la revendication 2, caractérisé par le fait qu'il contient des catalyseurs activables thermiquement pour le durcissement et réticulation thermiques des composants (a) et (b).

6. Mélange sensible à la lumière selon l'une des revendications 1 à 5, caractérisé par le fait que le polymère (a) est un copolymérisat d'acide (méth)acrylique, estérifié avec des O-nitrocarbinoles aromatiques et/ou hétéroaromatiques, de composés acryliques ou méthacryliques portant les autres groupes fonctionnels ainsi qu'éventuellement d'autres comonomères, en particulier des (méth)acrylates.

7. Matière d'enregistrement travaillant positivement, en particulier pour la préparation de dessins en relief, de formes en relief ou de modèles résists, stables à la température, comportant une couche durcissable sensible à la lumière, appliquée sur un support stable en dimensions, caractérisée par le fait que la couche durcissable, sensible à la lumière, est formée d'un mélange selon l'une des revendications 1 à 6.

8. Utilisation des mélanges sensibles à la lumière selon l'une des revendications 1 à 6, pour la préparation de dessins en relief, de formes en relief ou de modèles résists, en particulier pour la préparation de masques réserves de soudure.